# EUROPEAN PATENT SPECIFICATION

(11) **EP 0 494 597 B1**
(45) Date of publication and mention of the grant of the patent: **27.11.1996**
(21) Application number: 92100027.9
(22) Date of filing: 02.01.1992
(51) Int. Cl.: H01L 29/772, H01L 29/72, H01L 29/08, H01L 29/41, H01L 29/36, H01L 27/06, H01L 27/088, H01L 21/76

(54) **Trench-gate power semiconductor device**
Leistungshalbleiteranordnung mit einer Graben-Gateelektrode
Dispositif semi-conducteur de puissance à électrode de grille formée dans une tranchée

(30) Priority: 09.01.1991 JP 1083/91
(43) Date of publication of application: 15.07.1992
(73) Proprietor: KABUSHIKI KAISHA TOSHIBA, Kawasaki-shi, Kanagawa-ken 210 (JP)
(72) Inventor: Hiraki, Shunichi, c/o Intellectual Property Div., Minato-ku, Tokyo 105 (JP); Baba, Yoshiro, c/o Intellectual Property Division, Minato-ku, Tokyo 105 (JP)
(74) Representative: Lehn, Werner, Dipl.-Ing.

(56) References cited:
- US-A- 4 893 160
- US-A- 4 893 160
- IEEE TRANSACTIONS ON INDUSTRY APPLICATIONS vol. IA-22, no. 3, May 1986, NEW YORK US pages 466 - 469; H. YILMAZ ET AL.: 'Comparison of the punch-through and non-punch-through IGT structures'
- IEEE TRANSACTIONS ON ELECTRON DEVICES. vol. ED-34, no. 4, April 1987, NEW YORK US pages 926 - 930; D. UEDA ET AL.: 'An ultra-low on-resistance power MOSFET fabricated by using a fully self-aligned process'
- PROCEEDINGS OF THE IEEE 1987 CUSTOM INTEGRATED CIRCUITS CONFERENCE HELD IN PORTLAND, OREGON, US. May 1987, NEW YORK US pages 443 - 446; Y. OHATA ET AL.: 'Dielectrically isolated intelligent power switch'
- PATENT ABSTRACTS OF JAPAN vol. 14, no. 18 (E-873)(3961) 16 January 1990
- INTERNATIONAL ELECTRON DEVICES MEETING, HELD IN LOS ANGELES, CA, TECHNICAL DIGEST. December 1986, NEW YORK US pages 638 - 641; D. UEDA ET AL.: 'Deep-trench power MOSFET with an Ron area product of 160 mOhm.mm2'
- IEEE TRANSACTIONS ON ELECTRON DEVICES. vol. 35, no. 12, December 1988, NEW YORK US page 2459; S. MUKHERJEE ET AL.: 'TDMOS-An ultra-low on-resistance power transistor'

## Description

The present invention relates to a power MOS semiconductor device comprising a body of semiconductor material including a semiconductor substrate, a first semi-conductor layer having a first conductivity type on the substrate, a second semiconductor layer having a second conductivity type and formed in the first semiconductor layer to provide a channel, a third semiconductor layer having the first conductivity type and formed in the second semiconductor layer, a trench formed in the first semiconductor layer across the third and second semiconductor layers, a gate insulating film covering a surface of the trench and extending to a surface of the third semiconductor layer, a gate electrode layer provided on the gate insulating film, and a buried layer having the first conductivity type in the first semiconductor layer so as to be contiguous to the bottom of the trench.

Such a device is described in US-A-4 893 160. Further semiconductor devices are described in: IEEE IA-22, 3 (1986), pp 466-469; IEEE ED-34, 4 (1987), pp 926-930 and Proc. IEEE 1987, Custom Integrated Circuits Conference, pp 443-446.

As a conventional power MOSFET, a DMOS (Double diffusion MOS) structure has been generally used. However, such a structure has the following problems in order to increase the integration density by rendering the fine pattern structure thereto.
(1) A diffusion length of a lateral direction for forming a base region is limited to a pitch of design layout.
(2) A parasitic JFET (Junction FET) formed between contiguous base regions narrows a path through which a current vertically flows, thereby to increase a resistance component of a buffer layer.

The tendencies of the problems (1) and (2) occur remarkably when the design pitch is set to be small. As a result, since an optimum value is present in the layout, a decrease in on-resistance may be limited even if the integration density is increased. However, when the area of an element is increased to decrease the on-resistance, a production cost may be increased, and problems such as an unstable operation of the element or parasitic oscillation caused by parallel connection may be caused.

For this reason, a MOSFET having a gate formed in a trench, a source formed above the gate, and a substrate used as a drain has been developed. In this MOSFET using the trench, the above two drawbacks can be eliminated to improve the integration density and the decrease in the on-resistance.

In the MOSFET having the gate formed in the trench, the on-resistance can be decreased by increasing the depth of the trench. However, when the depth of the trench is increased, a breakdown voltage between the bottom of the trench and the drain may be lowered.

It is an object of-the present invention to provide a power MOS semiconductor device having a low on-resistance and a high breakdown voltage.

It is another object of the present invention to provide a power MOS semiconductor device capable of integrating other semiconductor elements.

According to the invention, the power MOS semiconductor device initially defined is characterised in that the buried layer is also contiguous to the upper surface of the substrate.

The novel and distinctive features of the invention are set forth in the claims appended to the present application. The invention itself, however, together with further objects and advantages thereof may best be understood by reference to the following description and accompanying drawings in which:
Fig. 1 is a side sectional view showing a power MOSFET according to a first embodiment of the present invention;
Fig. 2 is a graph showing a relation between an on-resistance and a depth of a trench in Fig. 1;
Fig. 3 is a graph showing a relation between the on-resistance and an impurity concentration of a substrate in Fig. 1;
Fig. 4 is a graph showing a relation between a breakdown voltage and the impurity concentration of the substrate in Fig. 1;
Fig. 5 is a graph showing a relation between an electric field strength and an impurity concentration of a buried layer in Fig. 1;
Fig. 6 is a side sectional view showing an IBGT according to a second embodiment of the present invention;
Fig. 7 is a side sectional view showing an IBGT according to a third embodiment of the present invention; and
Fig. 8 is a side sectional view showing an IPD according to a fourth embodiment of the present invention.

Embodiments of the present invention will be described below with reference to the accompanying drawings.

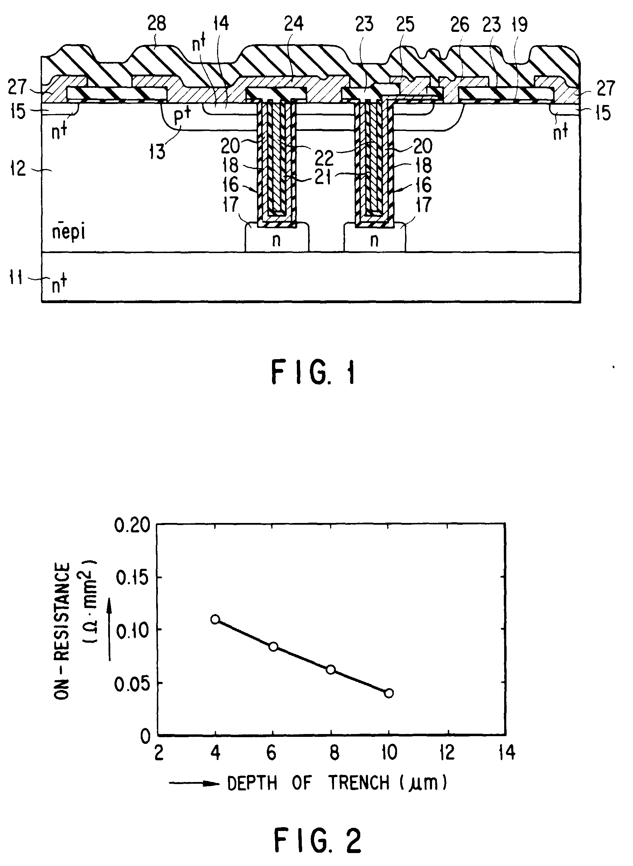

Fig. 1 is a power MOSFET according to the first embodiment of the present invention. In Fig. 1, an n⁺-type silicon substrate 11 serving as a drain has an impurity concentration of 1 × 10¹⁸ cm⁻³ or more. An epitaxial layer 12 of n⁻-type silicon is formed on the n⁺-type silicon substrate 11. The epitaxial layer 12 has a thickness of about 10 µm and an impurity concentration of 1 × 10¹⁵ cm⁻³. A channel region 13 of a p⁺-type impurity region is formed in the epitaxial layer 12, and a source region 14 of an n⁺-type impurity region is formed in the channel region 13. The channel region 13 has a diffusion thickness of 2.0 µm and an impurity concentration of 1 × 10¹⁸ cm⁻³, and the source region 14 has a diffusion thickness of 0.5 µm and an impurity concentration of 1 × 10²⁰ cm⁻³. When the source region 14 is provided, a channel stopper 15 for preventing a leak current from a junction edge is simultaneously formed. A trench 16 is formed in the epitaxial layer 12 across the source region 14 and the channel region 13, and an n-type buried layer 17 is provided between the bottom of the trench and the substrate 11. The buried layer 17 has a thickness of 3 to 4 µm and an impurity concentration of 1 × 10¹⁸ cm⁻³ to 1 × 10²⁰ cm⁻³. The buried layer 17 is formed by implanting impurity ions into the epitaxial layer 12 through the trench 16.

A gate oxide film (SiO₂) 18 is provided on the inner surface of the trench 16 to have a thickness of 500 to 1,000Å. The gate oxide film 18 is simultaneously formed when a thermal oxide film 19 of a field region is provided on the epitaxial layer 12. A gate electrode layer 20 of polysilicon is formed inside the gate oxide film 18 to a thickness of 4,000Å. A polysilicon oxide film 21 is provided inside the gate electrode layer 20 to have a thickness of 500Å. In addition, a buried polysilicon layer 22 is formed inside the polysilicon oxide film 21 to have a thickness of, e.g., 8,000Å.

An interlevel insulator 23 is provided on the thermal oxide film 19 and above the trench 16. The interlevel insulator 23 is composed of SiO₂, BPSG, or PSG. When the interlevel insulator 23 is provided by SiO₂, its thickness is 4,000Å. The thickness is 8,000Å in the case of BPSG. The thickness is 2,000Å in the case of PSG. In addition, a source electrode 24, a gate electrode 25, a field plate electrode 26 and a channel stopper electrode 27 are provided on the source region 14, the gate electrode layer 20, the channel region 13, and the channel stopper 15, respectively. Each of the electrodes 24 to 27 has a thickness of 1,500Å when they are made of Ti, and each of the electrodes 24 to 27 has a thickness of 4.0 µm when they are made of Aℓ. A final passivation film 28 of a plasma SiN is provided on the substrate surface to a thickness of 1.5 µm.

In the structure described above, a relation between a depth of the trench and an on-resistance and a relation between the on-resistance and an impurity carrier concentration of the epitaxial layer will be described below.

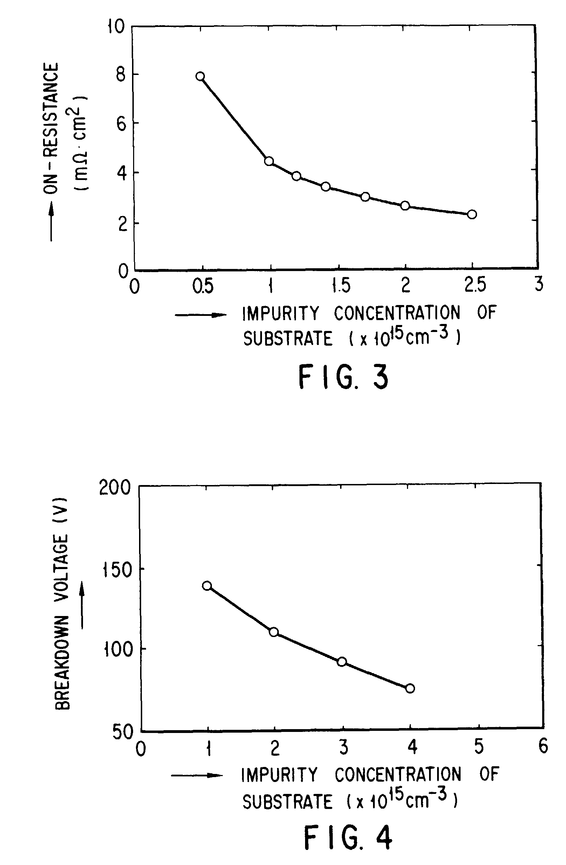

As shown in Fig. 2, the on-resistance is decreased as the bottom of the trench is close to the substrate. As shown in Fig. 3, as the impurity carrier concentration of the epitaxial layer is increased, the on-resistance is decreased. However, when the depth of the trench is increased to cause the bottom of the trench to be close to the substrate, a breakdown voltage is decreased. Furthermore, as the impurity carrier concentration of the epitaxial layer is increased, as shown in Fig. 4, the breakdown voltage is decreased. In the latter case, the decrease in breakdown voltage must be determined by considering the trade-off between the breakdown voltage and the on-resistance. In the former case, the decrease in breakdown voltage can be determined by lowering an electric field concentration at the bottom of the trench.

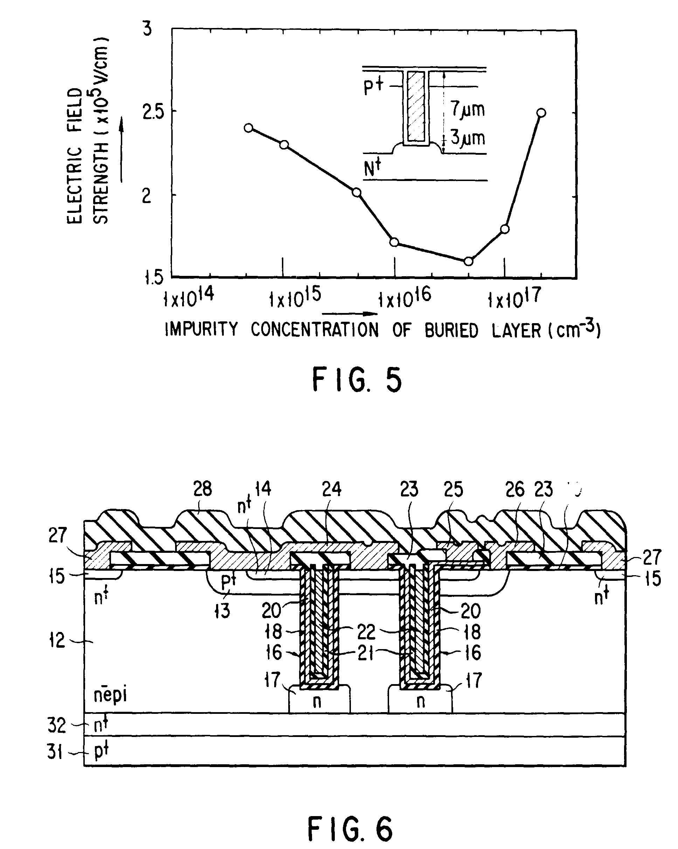

In the present invention, the buried layer 17 is provided between the bottom of the trench 16 and the substrate 11 to lower the electric field concentration. That is, as shown in Fig. 5, when the depth of the trench 16 is set to be 7 µm, the electric field strength can be reduced to 2 × 10⁵ V/cm in the buried layer 17 having the impurity concentration of 1 × 10¹⁵ cm⁻³ to 1 × 10¹⁷ cm⁻³.

According to the structure, the depth of the trench 16 in which the gate electrode layer 20 is provided is increased to 7 µm, so to be close to the substrate 11. Therefore, the on-resistance can be decreased without increasing the area of the device.

In addition, the buried layer 17 is provided between the bottom of the trench 16 and the substrate 11, and the impurity concentration of the buried layer 17 is set to be lower than that of the substrate 11 and higher than that of the epitaxial layer 12. For this reason, the electric field concentration at the bottom of the trench 16 can be reduced to increase the breakdown voltage.

Another embodiment of the present invention will be described below. The same reference numerals as in the first embodiment denote the same parts in the second embodiment, and the detailed description thereof will be omitted.

Fig. 6 shows the second embodiment in which the present invention is applied to an IGBT (Insulated Gate Bipolar Transistor).

In Fig. 6, an n⁺-type semiconductor layer 32 is provided on a p⁺-type silicon substrate 31 serving as a collector. The n⁻-type epitaxial layer 12 is provided on the semiconductor layer 32, and the trench 16, the buried layer 17 and the like are formed in the epitaxial layer 12.

According to the structure, the IGBT having a low on-resistance and a high breakdown voltage can be obtained.

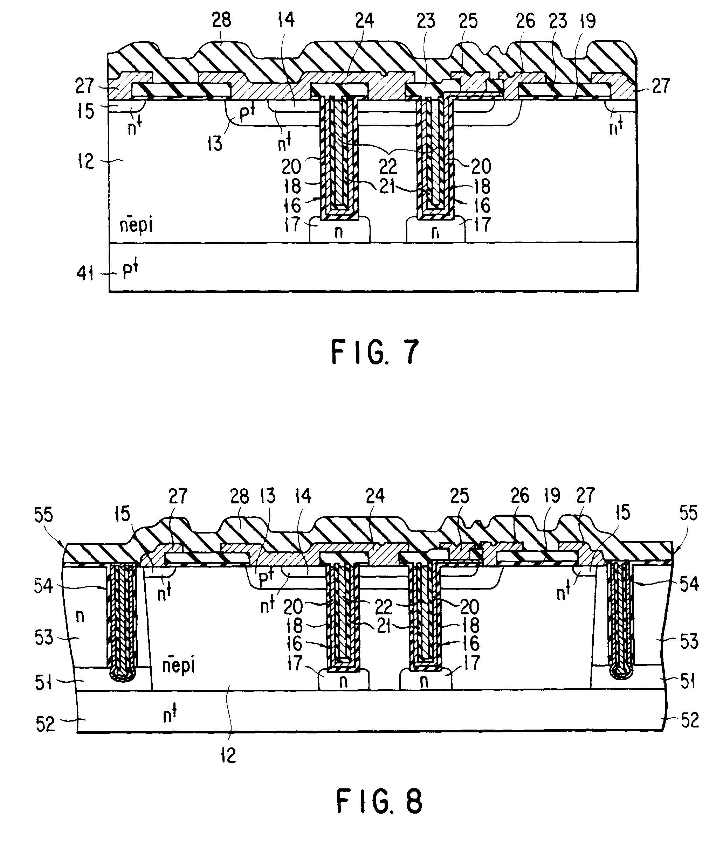

Fig. 7 shows the third embodiment of the present invention obtained by modifying the embodiment in Fig. 6.

In Fig. 6, the n⁺-type semiconductor layer 32 is formed on the p⁺-type silicon substrate 31. In this embodiment, however, the n⁻-type epitaxial layer 12 is provided on a p⁺-type silicon substrate 41, and the trench 16, the buried layer 17, and the like are formed in the epitaxial layer 12. According to the structure, the same advantages as described in the second embodiment can be obtained.

Fig. 8 shows the fourth embodiment of the present invention. The same reference numerals as in the first embodiment denote the same parts in the fourth embodiment, and the detailed description thereof will be omitted.

The embodiment shows an IPD (Intelligent Power Device) in which a power MOSFET and a small signal circuit including a C-MOS transistor or a bipolar transistor are provided in the same chip.

In this case, an n⁺-type substrate 52 and an n-type substrate 53 which are bonded to each other by a silicon oxide layer 51 are used. The epitaxial layer 12 is provided in the n-type substrate 53 in which the power MOSFET having the gate electrode formed in the trench of the epitaxial layer 12 is provided. In addition, an insulating region 54 connected to the silicon oxide film 51 is provided in the n-type substrate 53. The insulating region 54 is formed in the same step as that of forming the gate electrode layer in the trench. The n-type substrate 53 insulated by the insulating region 54 serves as a small signal circuit region 55, and a small signal circuit including a C-MOS transistor or a bipolar transistor is arranged in the small signal circuit region 55.

According to the structure, since the insulating region 54 can be formed in the same step as that of forming the power MOSFET having the gate electrode layer provided in the trench, the number of manufacturing steps can be reduced.

As described above, according to the present invention, the bottom of the trench in which the gate is provided is located to be close to the substrate, and the buried layer is provided between the bottom of the trench and the substrate. Therefore, the on-resistance can be decreased by increasing the depth of the trench.

In addition, since the impurity carrier concentration of the buried layer is set to be lower than the impurity carrier concentration of the semiconductor substrate and higher than the impurity carrier concentration of the epitaxial layer, the breakdown voltage can sufficiently be increased.

It is further understood by those skilled in the art that the foregoing description is only of the preferred embodiments and that various changes and modifications may be made in the invention without departing from the scope thereof.

## Claims

1. A power MOS semiconductor device comprising a body of semiconductor material including a semiconductor substrate (11; 32; 41; 52) having an impurity concentration, a first semi-conductor layer (12) having a first conductivity type with a lower impurity concentration thant that of the substrate on the substrate, a second semiconductor layer (13) having a second conductivity type and formed in the first semiconductor layer (12) to provide a channel, a third semiconductor layer (14) having the first conductivity type and formed in the second semiconductor layer (13), a trench (16) formed in the first semiconductor layer (12) across the third and second semiconductor layers (14, 13), a gate insulating film (18) covering a surface of the trench (16) and extending to a surface of the third semiconductor layer (14), a gate electrode layer (20) provided on the gate insulating film (18), and a buried layer (17) having the first conductivity type with an impurity concentration lower than that of the substrate and higher than that of the first layer in the first semiconductor layer (12) so as to be contiguous to the bottom of the trench (16)
characterised in that the buried layer (17) is also contiguous to the upper surface of the substrate (11; 32; 41; 52).

2. A power MOS semiconductor device according to claim 1,
wherein the semiconductor substrate (11; 32; 41; 52) has a high impurity concentration of first conductivity type to provide a vertical power MOSFET.

3. A power MOS semiconductor device according to claim 1,
wherein the substrate includes a lower semiconductor portion (31) having a high impurity concentration of the second conductivity type, and an upper semiconductor layer (32) having a high impurity concentration of the first conductivity type to provide an IGBT.

4. A power MOS semiconductor device according to claim 1,
wherein the semiconductor substrate (41) has a high impurity concentration of the second conductivity type to provide an IGBT.

5. A power MOS semiconductor device according to claim 1,
wherein the first semiconductor layer (12) is an epitaxial layer having a low impurity concentration.

6. A power MOS semiconductor device according to any preceding claim,
wherein conductive material (22), insulated by an insulating film (21), is buried in the trench (16).

7. A power MOS semiconductor device according to any preceding claim,
wherein the third and second semiconductor layers (14, 13) surround the trench (16) through the gate insulating film (18).

8. A power MOS semiconductor device according to any preceding claim,
wherein the body further includes a semiconductor substrate (53) having the first conductivity type to provide small signal circuit regions (55) isolated from one another.

9. A power MOS semiconductor device according to claim 8,
wherein each of the small signal circuit regions (55) includes a MOSFET.

10. A power MOS semiconductor device according to claim 8,
wherein each of the small signal circuit regions (55) includes a bipolar transistor.

11. A power MOS semiconductor device according to any preceding claim,
wherein the buried layer (17) has an impurity concentration of 5 × 10¹⁵ cm⁻³ to 1 × 10¹⁷ cm⁻³.

## Patentansprüche

1. Eine Leistungs- MOS Halbleitervorrichtung, die umfaßt: einen Körper aus Halbleitermaterial einschließlich eines Halbleitersubstrates (11; 32; 41; 52) mit einer Verunreinigungskonzentration, eine erste Halbleiterschicht eines ersten Leitfähigkeitstyps (12) auf dem Substrat, mit einer Verunreinigungskonzentration, die niedriger als die des Substrates ist, eine zweite Halbleiterschicht (13) eines zweiten Leitfähigkeitstyps und die in der ersten Halbleiterschicht (12) ausgebildet ist, um einen Kanal vorzusehen, eine dritte Halbleiterschicht (14) des ersten Leitfähigkeitstyps und die in der zweiten Halbleiterschicht (13) ausgebildet ist, ein Graben (16) der in der ersten Halbleiterschicht (12) durch die dritte und die zweite Halbleiterschicht (14, 13) gebildet ist, ein Gate-Isolierfilm (18), der die Oberfläche des Grabens (16) bedeckt und sich zu einer Oberfläche der dritten Halbleiterschicht (14) erstreckt, eine Gate-Elektrodenschicht (20), die auf dem Gate-Isolierfilm (18) vorgesehen ist, und eine vergrabenen Schicht (17) des ersten Leitfähigkeitstyps in ersten Halbleiterschicht (12) mit einer Verunreinigungskonzentration, die niedriger als die des Substrates und höher als die der ersten Schicht ist, so daß sie an den Boden des Grabens (16) angrenzt,
dadurch gekennzeichnet, daß
die vergrabene Schicht (17) auch an die obere Oberfläche des Substrates (11; 32; 41; 52) angrenzt.

2. Eine Leistungs- MOS Halbleitervorrichtung nach Anspruch 1, worin
das Halbleiterschicht (11; 32; 41; 52) eine hohe Verunreinigungskonzentration eines ersten Leitfähigkeitstyps hat, um einen vertikalen Leistungs-MOSFET vorzusehen.

3. Eine Leistungs- MOS Halbleitervorrichtung nach Anspruch 1, worin
das Substrat einen niedrigeren Halbleiterabschnitt (31) mit einer hohen Verunreinigungskonzentration des zweiten Leitfähigkeitstyps und eine obere Halbleiterschicht (32) mit einer hohen Verunreinigungskonzentration des ersten Leitfähigkeitstyps einschließt, um ein IGBT vorzusehen.

4. Eine Leistungs- MOS Halbleitervorrichtung nach Anspruch 1, worin
das Halbleitersubstrat (41) eine hohe Verunreinigungskonzentration des zweiten Leitfähigkeitstyps hat, um ein IGBT vorzusehen.

5. Eine Leistungs- MOS Halbleitervorrichtung nach Anspruch 1, worin
die erste Halbleiterschicht (12) eine Epitaxieschicht mit einer niedrigen Verunreinigungskonzentration ist.

6. Eine Leistungs- MOS Halbleitervorrichtung nach einem der vorhergehenden Ansprüche, worin
ein durch einen Isolierfilm (21) isoliertes leitfähiges Material (22) im Graben (16) vergraben ist.

7. Eine Leistungs- MOS Halbleitervorrichtung nach einem der vorhergehenden Ansprüche, worin
die dritte und zweite Halbleiterschicht (14, 13) den Graben (16) durch den Gate-Isolierfilm (18) umgeben.

8. Eine Leistungs- MOS Halbleitervorrichtung nach einem der vorhergehenden Ansprüche, worin
der Körper weiter ein Halbleitersubstrat (53) des ersten Leitfähigkeitstyps einschließt, um Kleinsignalschaltungsbereiche (55) vorzusehen, die voneinander isoliert sind.

9. Eine Leistungs- MOS Halbleitervorrichtung nach Anspruch 8, worin
jeder der Kleinsignalschaltungsbereiche (55) ein MOSFET einschließt.

10. Eine Leistungs- MOS Halbleitervorrichtung nach Anspruch 8, worin
jeder der Kleinsignalschaltungsbereiche (55) einen Bipolartransistor enthält.

11. Eine Leistungs- MOS Halbleitervorrichtung nach einem der vorhergehenden Ansprüche, worin
die vergrabene Schicht (17) eine Verunreinigungskonzentration von 5 x 10¹⁵ cm⁻³ bis 1 x 10¹⁷ cm⁻³ hat.

## Revendications

1. Dispositif de puissance à semiconducteurs MOS comprenant un corps d'un matériau semiconducteur incluant un substrat semiconducteur (11;32;41;52) ayant une concentration en impuretés, une premier couche semiconductrice (12) ayant un premier type de conductivité avec une concentration en impuretés inférieure à celle du substrat sur le substrat, une deuxième couche semiconductrice (13) ayant un second type de conductivité et formée dans la première couche semiconductrice (12) pour fournir un canal, une troisième couche semiconductrice (14) ayant le premier type de conductivité et formée dans la deuxième couche semiconductrice (13), une tranchée (16) formée dans la première couche semiconductrice (12) à travers les troisième et deuxième couches semiconductrices (14,13), un film isolant de grille (18) recouvrant une surface de la tranchée (16) et s'étendant jusqu'à une surface de la troisième couche semiconductrice (14), une couche d'électrode de grille (20) prévue sur le film isolant de grille (18), et une couche enfouie (17) ayant le premier type de conductivité avec une concentration en impuretés inférieure à celle du substrat et supérieure à celle de la première couche dans la première couche semiconductrice (12) de manière à ce qu'elle soit contiguë au fond de la tranchée (16),
caractérisé en ce que la couche enfouie (17) est également contiguë à la surface supérieure du substrat (11;32;41;52).

2. Dispositif de puissance à semiconducteurs MOS selon la revendication 1,
dans lequel le substrat semiconducteur (11;32;41;52) a une concentration élevée en impuretés du premier type de conductivité pour fournir un transistor MOSFET de puissance vertical.

3. Dispositif de puissance à semiconducteurs MOS selon la revendication 1,
dans lequel le substrat comprend une partie semiconductrice inférieure (31) ayant une concentration élevée en impuretés du second type de conductivité, et une couche semiconductrice supérieure (32) ayant une concentration élevée en impuretés du premier type de conductivité pour fournir un transistor IGBT.

4. Dispositif de puissance à semiconducteurs MOS selon la revendication 1,
dans lequel le substrat semiconducteur (41) a une concentration élevée en impuretés du second type de conductivité pour fournir un transistor IGBT.

5. Dispositif de puissance à semiconducteurs MOS selon la revendication 1,
dans lequel la première couche semiconductrice (12) est une couche épitaxiale ayant une faible concentration en impuretés.

6. Dispositif de puissance à semiconducteurs MOS selon l'une quelconque des revendications précédentes,
dans lequel un matériau conducteur (22), isolé par un film isolant (21), est enfoui dans la tranchée (16).

7. Dispositif de puissance à semiconducteurs MOS selon l'une quelconque des revendications précédentes,
dans lequel les troisième et deuxième couches semiconductrices (14,13) entourent la tranchée (16) par l'intermédiaire du film isolant de grille (18).

8. Dispositif de puissance à semiconducteurs MOS selon l'une quelconque des revendications précédentes,
dans lequel le corps comprend en outre un substrat semiconducteur (53) ayant le premier type de conductivité pour fournir des régions de petits circuits de signaux (55) isolées les unes des autres.

9. Dispositif de puissance à semiconducteurs MOS selon la revendication 8,
dans lequel chacune des régions de petits circuits de signaux (55) comprend un transistor MOSFET.

10. Dispositif de puissance à semiconducteurs MOS selon la revendication 8,
dans lequel chacune des régions de petits circuits de signaux (55) comprend un transistor bipolaire.

11. Dispositif de puissance à semiconducteurs MOS selon l'une quelconque des revendications précédentes,
dans lequel la couche enfouie (17) a une concentration en impuretés de 5 x 10¹⁵ cm⁻³ à 1 x 10¹⁷ cm⁻³.
